# EUROPEAN PATENT APPLICATION

(11) **EP 4 718 960 A1**
(43) Date of publication of application: **01.04.2026**
(21) Application number: 24810815.1
(22) Date of filing: 22.04.2024
(51) Int. Cl.: H05K 7/20, H01L 23/44

(54) **ELECTRONIC DEVICE AND METHOD FOR COOLING ELECTRONIC ELEMENT**

(30) Priority: 22.05.2023 JP 2023083777
(71) Applicant: The Bizser Co., Ltd., Chiyoda-ku Tokyo 101-0021 (JP)
(72) Inventor: NIREI Atsushi, Tokyo 121-0075 (JP); KIKUCHI Shinichi, Narita-shi, Chiba 286-0048 (JP)
(74) Representative: Blumbach · Zinngrebe Patentanwälte PartG mbB
(86) International application number: PCT/JP2024/015716
(87) International publication number: WO 2024/241807

(57) **Abstract**

The present invention provides an electronic device and a method for cooling an electronic element capable of reducing environmental burden. The electronic device comprises an electronic element for performing electronic processing and a cooling liquid for cooling the electronic element by immersing the electronic element therein, wherein the cooling liquid is water that has been transitioned from a state at a temperature exceeding a critical temperature and a pressure exceeding a critical pressure to a state at normal temperature and normal pressure.

## Description

### TECHNICAL FIELD

The present invention relates to an electronic device and to a method for cooling an electronic element.

### BACKGROUND ART

Techniques have been proposed in which an electronic element provided in an electronic device is cooled effectively by immersing the electronic element in a cooling liquid. In Patent Document 1, it has been proposed to use a specific fluorinated compound as the cooling liquid for cooling the electronic element.

### PRIOR ART DOCUMENT

### PATENT DOCUMENT

Patent Document 1: Japanese Patent Publication No. 2023-510374

### SUMMARY OF INVENTION

### PROBLEM TO BE SOLVED BY THE INVENTION

In the technique proposed in Patent Document 1, there is a problem related to the treatment of waste cooling liquid. Improvement was desired from the viewpoint of reducing environmental burden.

An object of the present invention is to provide an electronic device and a method for cooling an electronic element capable of achieving a reduction in environmental burden.

### MEANS FOR SOLVING THE PROBLEM

The present invention relates to:
(1) an electronic device including an electronic element for performing electronic processing and a cooling liquid for immersing and cooling the electronic element, the cooling liquid being water that has been transitioned from a state at a temperature exceeding a critical temperature and a pressure exceeding a critical pressure to a state at normal temperature and normal pressure;
(2) the electronic device according to (1), further including a circuit board having circuit wiring electrically joined to terminals of the electronic element using metal;
(3) the electronic device according to (2), wherein the circuit board has an immersion region immersed in the cooling liquid and a non-immersion region not immersed in the cooling liquid, and the electronic element is disposed in the immersion region;
(4) the electronic device according to (2), wherein the circuit board is waterproof-coated;
(5) the electronic device according to (1) or (2), further including a cooling tank for storing the cooling liquid, the cooling tank being provided with a circulator for circulating the cooling liquid, the circulator being configured to dissipate heat from the cooling liquid; and
(6) a method of cooling an electronic element of an information processing device having an electronic element for performing electronic processing, the method including:
   cooling the electronic element by immersing the electronic element in a cooling liquid; and
   wherein the cooling liquid is water that has been transitioned from a state at a temperature exceeding a critical temperature and a pressure exceeding a critical pressure to a state at normal temperature and normal pressure.

### EFFECT OF THE INVENTION

According to the present invention, it is possible to provide an electronic device and a method for cooling an electronic element capable of achieving a reduction in environmental burden.

### BRIEF DESCRIPTION OF DRAWINGS

FIG. 1 is a diagram illustrating an example of an electronic device according to the first embodiment.
FIG. 2 is a configuration diagram illustrating an example of the configuration of the electronic device according to the first embodiment.
FIG. 3 is a diagram illustrating a method for producing supercritical state passed water.
FIG. 4A is a diagram illustrating an example of an electronic device according to Modified Example 1 of the first embodiment.
FIG. 4B is a sectional view schematically illustrating an example of the state of the longitudinal sectional of line F-F in FIG. 4A.
FIG. 5 is a diagram illustrating an example of an electronic device according to Modified Example 3 of the first embodiment.
FIG. 6 is a diagram illustrating an example of an electronic device according to the second embodiment.
FIG. 7 is a flowchart illustrating an example of the method for cooling an electronic element.

### DESCRIPTION OF EMBODIMENTS

In the following, embodiments of the present invention will be described in sequence: "electronic device" and "method for cooling an electronic element." With respect to the "electronic device," the description will proceed in the order of "1. First Embodiment" and "2. Second Embodiment."

It should be noted that the present invention is not limited to the embodiments described below.

### [Electronic Device]

The electronic device according to the present invention may include, as examples, apparatuses that are capable of generating heat during operation. For example, the electronic device may be a computer, a supercomputer, a quantum computer, an inverter, a converter, a motor drive unit, a communication apparatus (for example, a 5G (5th Generation Mobile Communication System) or a 6G (6th Generation Mobile Communication System)), or a control apparatus for a robot or the like (power-system apparatus).

### [1. First Embodiment]

### [1 1. Configuration]

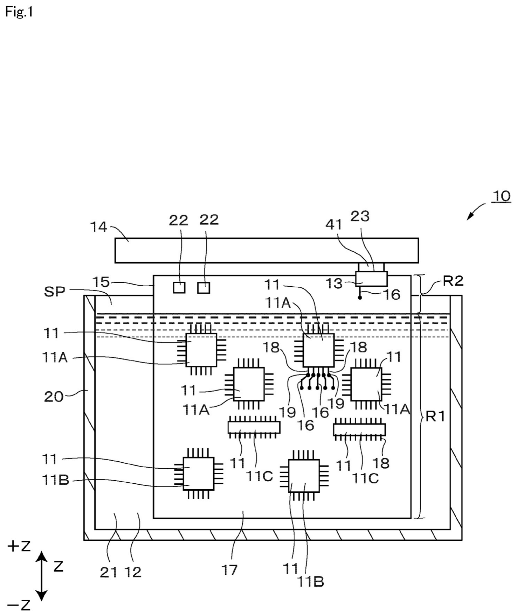

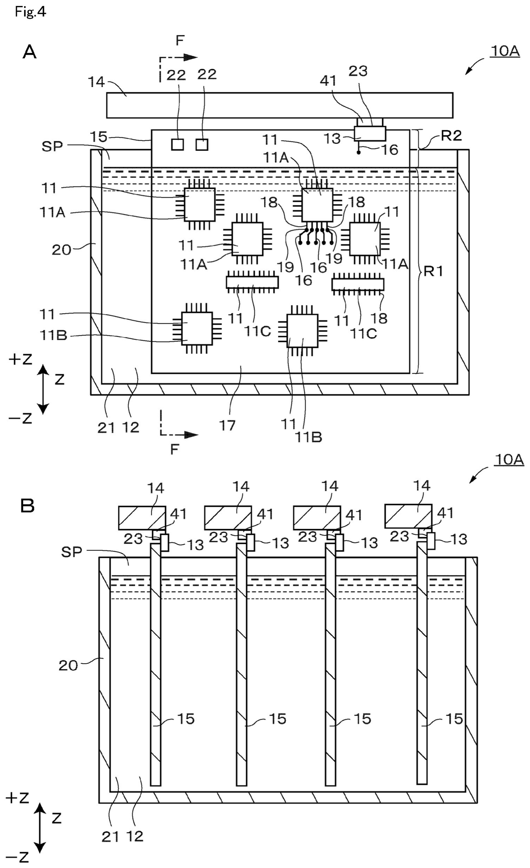

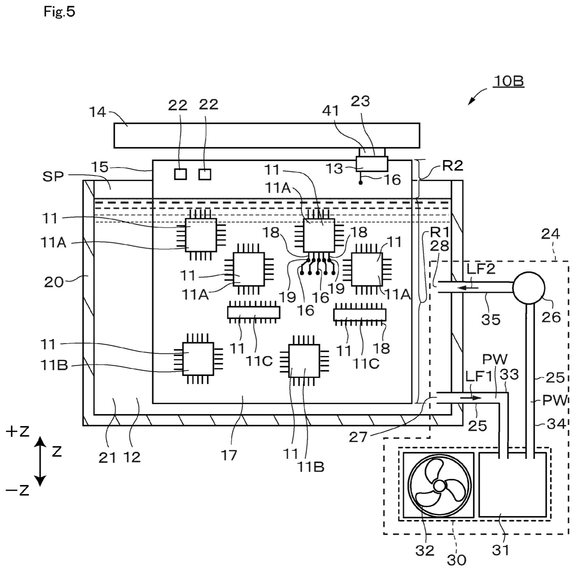

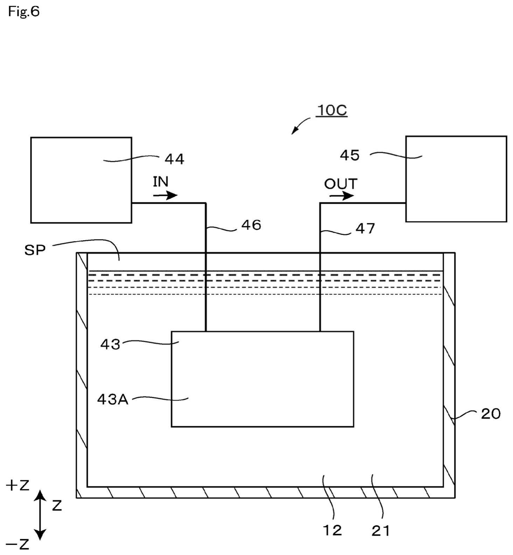

With reference to FIGS. 1 etc., an electronic device according to the first embodiment will be described. FIG. 1 is a cross sectional view illustrating an example of the electronic device according to the first embodiment. In FIG. 1, an example is shown in which the electronic device is an information processing device such as a computer. In the first embodiment of "electronic device," the description continues with the case where the electronic device is an information processing device as an example. In addition, in FIG. 1, the Z axis direction is taken as the vertical direction, with the +Z arrow direction as upward and the -Z arrow direction as downward. The same applies to FIGS. 4A, 4B, and 5, and also to FIG. 6, which illustrates the second embodiment described below.

The electronic device 10 according to the first embodiment includes an electronic element 11 and further includes a cooling liquid 12 for immersing and cooling the electronic element 11, as shown in the example of FIG. 1.

### (Electronic element)

The electronic element 11 is an element that performs electronic processing. As examples of the electronic element 11, a chipset using semiconductor elements can be exemplified. The type of the electronic element 11 is not particularly limited, but examples include those that generate heat under conditions associated with electrical signal exchange or those whose functions may be impaired by heat (elements more vulnerable to heat than other elements described below). Specifically, the electronic element 11 can be an information processing element, a memory element, or a power element. As information processing elements, there may be exemplified arithmetic elements, control elements, a CPU (Central Processing Unit), a GPU (Graphics Processing Unit), an MPU (Micro Processing Unit), and the like. As memory elements, nonvolatile memories such as flash memories and volatile memories such as RAMs can be exemplified. The power element is a power semiconductor or an element including a power semiconductor. A power semiconductor is a semiconductor capable of handling high voltages and large currents. In general, power semiconductors have structures different from ordinary semiconductors so as not to break even under high voltages and/or large currents. Such power semiconductors are known to generate heat and become high-temperature due to handling large amounts of power.

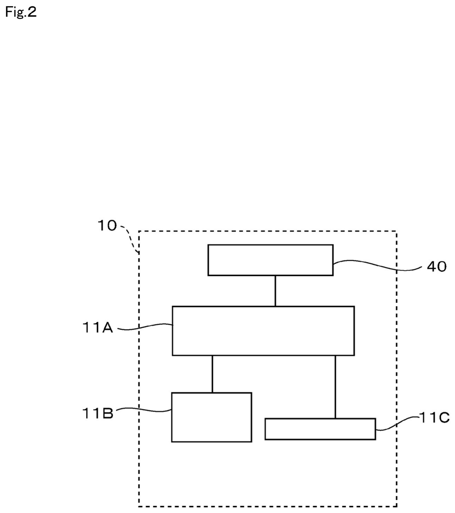

The various electronic elements 11 described above may be selected in accordance with conditions such as the functions of the electronic device 10. For example, in the example of FIG. 2, the electronic device 10 includes, as electronic elements 11, a CPU 11A, a GPU 11B, a memory 11C, and the like, and the CPU 11A, the GPU 11B, and the memory 11C are electrically connected. FIG. 2 is a configuration diagram illustrating an example of the configuration of the main electronic elements 11 in the example of the electronic device 10 shown in FIG. 1. In addition, in the example shown in FIG. 2, the GPU 11B and the memory 11C are connected so as to be capable of electrically transmitting signals to the CPU 11A, and the CPU 11A is connected so as to be capable of electrically transmitting signals to an I/O port 40. Furthermore, in the example of FIG. 2, the I/O port 40 is configured to be capable of transmitting signals to other devices, and for example, having external connection terminal 13 shown in FIG. 1. In FIG. 2, the case where the external connection terminal 13 is connected to an external device 14 is illustrated. In FIG. 2, for ease of explanation, only signal lines are shown for wiring, and other structures or devices (such as the external device 14) electrically connected to the electronic elements 11 via signal lines, as well as the power supply and power supply lines, are omitted. In addition, the example of FIG. 2 is merely an example of a configuration of the electronic elements 11 and does not limit the type, layout, or interconnection state of the electronic elements 11. Additionally, a device connected via the I/O port 40 (such as the external device 14) may or may not be included in the electronic device 10.

The electronic device 10 includes a circuit board 15, and as shown in FIG. 1, the electronic element 11 is mounted on the circuit board 15. The electronic element 11 is electrically connected to wiring 16 formed on the circuit board 15. In the example of FIG. 1, the CPU 11A, GPU 11B, and memory 11C, as examples of the electronic element 11, are mounted at predetermined positions on the circuit board 15. In addition, in FIG. 1, for convenience of explanation, only part of the wiring 16 is shown, and description of other wiring is omitted. The same applies to FIGS. 4A and 5.

### (Circuit board)

The circuit board 15 includes a substrate body 17 and wiring 16. The wiring 16 is electrically joined to terminals 18 of the electronic element 11, and has an element bonding portion 19 at the junction between the wiring 16 and the terminals 18 of the electronic element 11.

The element bonding portion 19 preferably has a structure for restricting the formation of a state in which the cooling liquid 12 intervenes between the wiring 16 and the electronic element 11 (preferably a structure that blocks the cooling liquid 12 from entering between the wiring 16 and the electronic element 11). From this perspective, it is preferable that the element bonding portion 19 be formed by joining the wiring 16 and the terminals 18 of the electronic element 11 using metal. Accordingly, the method for forming the element bonding portion 19 is not particularly limited, but it is preferable to employ a joining method using metal.

As examples of metal-based joining methods employable for forming the element bonding portion 19, metal fusion bonding and crimp bonding can be exemplified. Metal fusion bonding includes a soldering method, in which the wiring 16 and the terminals 18 of the electronic element 11 are joined with solder, and a wire bonding method, among others. Crimp bonding exemplifies a method of directly joining (metal bonding) the wiring 16 and the terminals 18 of the electronic element 11.

The material of substrate body 17 is not particularly limited; for example, a glass epoxy substrate, a bakelite substrate, a fluororesin substrate, a flexible substrate using PET film, or the like may be employed. The material of wiring 16 is not particularly limited so long as it is a metal capable of forming a circuit on substrate body 17, and may be at least one species selected from the group consisting of copper, silver, gold, and aluminum. In the case where the wiring 16 and terminal 18 of electronic element 11 are connected by a wire bonding method, the material of the wire is not particularly limited and may be a metal usable as wiring 16 (for example, gold).

In addition, in the example of FIG. 1, a single circuit board 15 mounts various electronic elements 11 such as semiconductor element based chipsets (for example, CPU 11A, GPU 11B) and memory 11C, and an external connection terminal 13 is also mounted thereon. Electronic device 10 may further include, as other electronic elements 11 besides CPU 11A and GPU 11B, additional semiconductor element based chipsets. The functions of any additionally provided chipsets may be determined in accordance with the functional requirements of the electronic device 10.

### (Cooling of electronic element)

The electronic device 10 includes the cooling liquid 12 as described above. The electronic device 10 has a structure in which electronic element 11 is immersed in cooling liquid 12. In the electronic device 10, some of the electronic elements 11 may be immersed in cooling liquid 12, and all of the electronic elements 11 may be immersed in cooling liquid 12.

### (Immersion region and non immersion region)

In the electronic device 10 according to the first embodiment, circuit board 15 may be entirely immersed in cooling liquid 12; however, as in the example of the electronic device 10 shown in FIG. 1, circuit board 15 may have an immersion region R1 in which it is immersed in cooling liquid 12 and a non immersion region R2 in which it is not immersed in cooling liquid 12. In other words, a portion of circuit board 15 may be immersed in cooling liquid 12. The immersion region R1 denotes a region of the surface of circuit board 15 to be immersed in cooling liquid 12. The non immersion region R2 denotes a region of the surface of circuit board 15 not to be immersed in cooling liquid 12. The non immersion region R2 corresponds to the region of the surface of circuit board 15 excluding the immersion region R1.

In the Electronic device 10, it is preferable that the layout of electronic elements 11 on circuit board 15 be such that the electronic elements 11 are positioned within the immersion region R1. In this configuration, the electronic elements 11 can be reliably immersed in cooling liquid 12. In addition, in the electronic device 10, elements or components for which immersion in cooling liquid 12 is of little necessity (for example, elements or components that generate little heat or are heat resistant), and elements or components that are preferably kept out of contact with cooling liquid 12 (for example, external connection terminals 13), are preferably arranged in the non immersion region R2.

In the example of the electronic device 10 shown in FIG. 1, cooling liquid 12 is contained in cooling tank 20, and at least a portion of circuit board 15 is arranged within internal space SP of cooling tank 20, with the immersion region R1 of circuit board 15 being immersed in cooling liquid 12. Further, in the example of FIG. 1, the region near the upper end portion of circuit board 15 serves as the non immersion region R2, and the region below the non immersion region R2 serves as the immersion region R1. An external connection terminal 13 is provided in the non immersion region R2 near the upper end portion of circuit board 15, and the external connection terminal 13 is disposed outside cooling tank 20. In the immersion region R1, electronic elements 11 such as CPU 11A, GPU 11B, and memory 11C are provided, and all of them are immersed in cooling liquid 12.

### (Cooling tank)

The cooling tank 20 is not particularly limited as long as it is configured so as to be capable of containing cooling liquid 12 and forming a state in which electronic element 11 is immersed in the cooling liquid 12. In the example of FIG. 1, the cooling tank 20 is a housing having its upper surface (the +Z direction in FIG. 1) opened. In addition, the cooling tank 20 shown in FIG. 1 is merely an example and does not limit the shape or structure of cooling tank 20. The material of cooling tank 20 is not particularly limited as long as it is capable of storing cooling liquid 12 and does not interfere with the operation of electronic element 11 or the energization of wiring 16 disposed on circuit board 15; for example, plastics such as acrylic resin or types of glass may be employed.

### (Cooling liquid)

The cooling liquid 12 is a liquid for immersing and cooling electronic element 11. Specifically, the cooling liquid 12 is supercritical state passed water 21. The cooling liquid 12 is not prohibited from being a liquid that contains components other than the supercritical state passed water 21, as long as such components do not affect the operation of electronic element 11 or circuit board 15 immersed therein; however, from the viewpoint of cooling stability, it is more preferable that no additional components be added to the supercritical state passed water 21.

### (Supercritical-state-passed water)

In the present specification, the term "supercritical state passed water 21" refers to water that has undergone a transition from a supercritical state to a state under normal temperature and normal pressure. The supercritical state refers to a condition in which both the temperature exceeds the critical temperature and the pressure exceeds the critical pressure. In addition, the combination of the critical temperature and critical pressure is sometimes referred to as the critical condition. In the present specification, the term "normal temperature" refers, for example, to a temperature of approximately 1°C to 35°C. The term "normal pressure" refers, for example, to a pressure of approximately 1 atm (about 0.1013 MPa). In addition, "normal temperature" may also refer to the room temperature in the human living environment, and "normal pressure" may also refer to the atmospheric pressure in the human living environment.

### (Production apparatus and production method for supercritical state passed water)

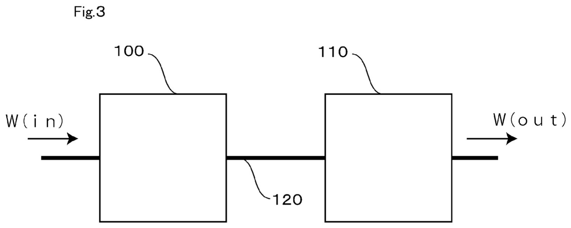

The supercritical state passed water 21 can be produced using, for example, an apparatus such as that shown in FIG. 3. FIG. 3 is a diagram showing an example of a production apparatus for supercritical state passed water 21. The following description with reference to FIG. 3 is merely an example, and the production apparatus and production method for supercritical state passed water 21 are not limited to the example described herein.

The production apparatus for supercritical state passed water 21 illustrated in FIG. 3 includes a pressure raising unit 100 and a temperature raising unit 110, and is provided with piping 120 for connecting the pressure raising unit 100 and the temperature raising unit 110. The pressure raising unit 100 may be, for example, a pressurizing device such as a high pressure pump. The temperature raising unit 110 may be, for example, a known heating heater.

In the production apparatus of FIG. 3, feed water (hereinafter referred to as raw water) indicated by reference numeral W(in) in FIG. 3 is fed into the pressure raising unit 100, and within the pressure raising unit 100, the pressure of the water is raised to a pressure exceeding the critical pressure of water (about 22 MPa). The temperature within the pressure raising unit 100 is set to a level that prevents solidification of the raw water therein. Next, the fluid pressurized by the pressure raising unit 100 is conveyed via piping 120 to the temperature raising unit 110. In the temperature raising unit 110, the fluid is heated to a temperature exceeding the critical temperature of water (about 374 °C). At this time, the fluid within the temperature raising unit 110 is in a state in which both the temperature and pressure exceed the critical conditions of water (pressure: about 22 MPa; temperature: about 374 °C), i.e., a supercritical state. After heating, the fluid within the temperature raising unit 110 is reduced in temperature and pressure to normal temperature and normal pressure. This causes the fluid to transition to a state under normal temperature and normal pressure, i.e., to the liquid water state. Thereafter, the fluid discharged from the temperature raising unit 110 forms the supercritical state passed water 21 (indicated by reference numeral W(out) in FIG. 3). The step of reducing the temperature and pressure in the temperature raising unit 110 to normal temperature and normal pressure can be achieved, for example, by providing a cooling device and a decompression device in the temperature raising unit 110.

The raw water used to produce the supercritical state passed water 21 is not particularly limited and may, for example, be tap water, mineral water, or pure water; however, from the standpoint of minimizing impurities, it is preferable that the raw water be pure water.

The pressurizing mechanism of pressure raising unit 100 is not particularly limited so long as it can raise the pressure of water to at least the critical pressure of water. For example, in addition to pressurization by a high-pressure pump, the pressurizing mechanism may comprise filling a conduit continuously extending from a high location to a low location with raw water so as to position the water surface at the high location, thereby increasing the hydrostatic pressure at the low location and pressurizing the raw water situated there. The height of the high location for achieving the critical pressure of water may be set to a position approximately 2,200 m or more above the low location.

The temperature raising mechanism of temperature raising unit 110 is not particularly limited as long as it can raise the temperature of water to a level exceeding the critical temperature of water. For example, the use of combustion heat from organic substances, the use of light energy such as sunlight, and the use of heat generated by passing current through heating elements such as electric heating wires may be exemplified.

In the above production apparatus, the pressure raising unit 100 and the temperature raising unit 110 are connected by piping 120, and pressurization and temperature raising have been performed separately; however, pressurization and temperature raising may be performed simultaneously, for example by providing the temperature raising unit 110 within the pressure raising unit 100.

### (Other elements and other circuit boards)

The electronic device 10 may include, in addition to the electronic elements described above, "other elements." Examples of other elements include elements for which cooling is of little necessity. As examples of other elements, capacitors, resistors, and coils (inductors) may be exemplified. As shown in FIG. 2, other elements 22 for which cooling is of little necessity are preferably arranged in the non immersion region R2. Water resistant capacitors, resistors, and the like may be arranged in the immersion region R1, and water sensitive capacitors, resistors, and the like may be arranged in the non immersion region R2. It should be noted that FIG. 2 is an example, and the layout of elements 22 in the electronic device 10 is not limited to the layout shown in FIG. 2.

The electronic device 10 is not excluded from including elements and/or components that may cause functional degradation or malfunction of the electronic device 10 when immersed in the supercritical state passed water 21 described below. Such elements and/or components are those that are preferably not brought into contact with the cooling liquid 12. Examples of such elements and/or components include terminals for electrically connecting to the external device 14 and/or a power supply (for example, the external connection terminal 13 described above).

In the electronic device 10, another circuit board different from circuit board 15, which is not immersed in cooling liquid 12, may further be provided (not shown).

As an "other circuit board" not immersed in cooling liquid 12, a circuit board on which the "other elements" described above are mounted may be exemplified. For example, the electronic device 10 has a circuit board 15 (first circuit board) on which a CPU, GPU, and memory are mounted, and may further include, as a circuit board different from the first circuit board, another circuit board (second circuit board) (not shown). In this case, in the electronic device 10, the "other elements" such as external connection terminal 13 may be mounted on the second circuit board. At least a portion of the first circuit board is immersed in cooling liquid 12, while the second circuit board is not immersed in cooling liquid 12. In addition, the first circuit board and the second circuit board may be electrically connected.

### [1 2. Operation and Effects]

In order to avoid degradation or destruction of the function of the electronic device 10 caused by heat generation of the electronic elements 11 accompanying operation of the electronic device 10, techniques for cooling the electronic elements 11 have been proposed. As a technique for cooling the electronic elements 11, there has been proposed a technique in which a specific fluorinated compound is used as the cooling liquid and the electronic elements 11 are immersed in that cooling liquid. However, because a fluorinated compound is used, there is a problem concerning the treatment of waste liquid, and from the viewpoint of reducing environmental burden, improvement has been desired.

According to the electronic device 10 of the first embodiment, since the cooling liquid 12 is supercritical state passed water 21, the problem of waste liquid treatment can be resolved. Generally, when a circuit board on which electronic elements 11 are mounted is immersed in pure water, the metals constituting the electronic elements 11 and wiring 16 dissolve into the pure water, and within a short period cause short circuits or destruction of the electronic elements 11, thereby impairing the operation of the circuit board 15. In this regard, according to the electronic device 10 of the present invention, by using supercritical state passed water 21 as the cooling liquid 12, the risk of impairment of operation of circuit board 15 within a short period can be reduced.

According to the electronic device 10 of the first embodiment, because electronic element 11 is immersed in cooling liquid 12, electronic element 11 can also be effectively cooled from the standpoint of the increased contact area between electronic element 11 and the cooling medium (cooling liquid).

### [1 3. Modified Examples]

### (Modified Example 1)

In the electronic device 10 of the first embodiment, as shown in FIGS. 4A and 4B, the circuit boards immersed in cooling liquid 12 may be plural. FIG. 4A is a side view illustrating an exemplary embodiment of Modified Example 1 (electronic device 10A) according to the first embodiment. FIG. 4B is a sectional view schematically illustrating an example of the state of the longitudinal section along line F-F of the electronic device 10A shown in FIG. 4A. In addition, in FIGS. 4A and 4B, although multiple circuit boards 15 region Rranged in the common internal space SP of cooling tank 20, this is merely an example. The internal space SP within cooling tank 20 may be partitioned into multiple spaces, and circuit boards 15 may be arranged in each partitioned space. In this case, at least a portion of each circuit board 15 can be immersed in cooling liquid 12 contained in each partitioned space. In addition, in FIG. 4B, for the sake of convenience in description, wiring 16, electronic elements 11, and other elements 22 are omitted.

### (Modified Example 2)

In the electronic device 10 of the first embodiment, it is preferable that circuit board 15 be provided with a waterproof coating or a moisture proof coating. The application of a waterproof coating is referred to herein as a waterproof treatment. The waterproof treatment can be carried out, for example, by forming a waterproof layer on predetermined portions of circuit board 15. Examples of the waterproof layer include an organic resin layer and an inorganic insulating layer. Specifically, various resins usable as sealing materials-such as silicone based resins, acrylic based resins, and fluorine based resins-may be exemplified. As a method for performing the waterproof treatment, spray coating can be exemplified.

The waterproof treatment may be carried out by forming a waterproof layer over the entirety of circuit board 15. Alternatively, the waterproof treatment may be carried out by forming a waterproof layer on a portion of circuit board 15. Specifically, when circuit board 15 includes an immersion region R1 and a non immersion region R2, it is preferable that the waterproof treatment be applied at least to the immersion region R1. In the electronic device 10 configured in this manner, the portions of circuit board 15 that contact the supercritical state passed water 21 serving as cooling liquid 12 are waterproof coated. Accordingly, in the electronic device 10, even if circuit board 15 itself tends to absorb moisture, or is prone to circuit abnormalities upon moisture uptake, expansion, deformation, and circuit failures of circuit board 15 due to moisture penetration can be suppressed.

With respect to circuit board 15, the waterproof treatment is preferably applied at least to the portions where elements or components (for example, external connection terminals 13), preferably not contacting cooling liquid 12, are mounted, and to the joint portions that join different elements or components (for example, the connection portion 23 to the connection terminal 41 of external device 14 and the element bonding portion 19). In addition, the connection portion 23 and the element bonding portion 19 may collectively be referred to as connection portions. In the electronic device 10 configured in this manner, infiltration of the supercritical state passed water into the connection portions can be suppressed, thereby reducing the risk of insulation between the connection terminal 41 of external device 14 and the external connection terminal 13 of circuit board 15, or between different elements or components.

It is also preferable to suppress contact of ordinary water (such as tap water) with the connection portions, as the entry of tap water into the connection portions may cause a short circuit on the circuit board at or around the connection portions. Therefore, the effects of applying the waterproof treatment are considered to differ between the effect of preventing the entry of supercritical state passed water into the connection portions and the effect of preventing the entry of tap water into the connection portions.

### (Modified Example 3)

In the electronic device 10 of the first embodiment, when the device includes a cooling tank 20 for storing cooling liquid 12, the cooling tank 20 may be provided with a circulator 24 that circulates cooling liquid 12 as shown in FIG. 5. FIG. 5 is a diagram illustrating an exemplary embodiment of Modified Example 3 (electronic device 10B) of the electronic device 10.

### (Circulator)

The circulator 24 is not particularly limited so long as it is configured to be capable of discharging cooling liquid 12 contained in cooling tank 20 and reintroducing cooling liquid 12 into cooling tank 20. In the example of FIG. 5, circulator 24 includes a flow channel forming member 25 that forms a liquid flow path PW and a liquid delivery unit 26 that has a function of delivering cooling liquid 12 into the flow channel forming member 25. The flow channel forming member 25 may be constituted by piping formed of plastic or the like. The flow channel forming member 25 connects the ports of the liquid flow path PW (the inlet 27 and the outlet 28) to cooling tank 20. Cooling liquid 12 contained in cooling tank 20 flows from the inlet 27 in the direction of arrow LF1 into the flow channel forming member 25, then through the flow channel forming member 25 and returns from the outlet 28 in the direction of arrow LF2 back into cooling tank 20. The liquid delivery unit 26 may, for example, be a pump.

The electronic device 10B has a circulator 24, which enables the formation of a flow in the cooling liquid 12 in the cooling tank 20 and also enables the formation of a flow in the cooling liquid 12 surrounding electronic elements 11. For this reason, the risk of a reduction in cooling performance due to an increase in the temperature of the cooling liquid 12 around electronic elements 11 caused by heat generated by the electronic elements 11 and the like is reduced.

In the electronic device 10B, as shown in FIG. 5, the circulator 24 is preferably further configured to allow heat dissipation of the cooling liquid 12.

In the example of the electronic device 10B shown in FIG. 5, the circulator 24 includes a heat dissipation unit 30 for dissipating heat from the cooling liquid 12.

### (Heat Dissipation Unit)

The heat dissipation unit 30 is not particularly limited so long as it is configured to lower the temperature of cooling liquid 12 that has flowed into the liquid flow path PW from inlet 27. The heat dissipation unit 30 includes a heat dissipation tank 31 and a fan 32. In the example of FIG. 5, the heat dissipation tank 31 connects the first tube 33 and the second tube 34 that constitute the flow channel forming member 25. One end of the first tube 33 is connected to cooling tank 20 and forms inlet 27. Cooling liquid 12 flowing from inlet 27 into the first tube 33 is sent from the first tube 33 to the heat dissipation tank 31. Heat from cooling liquid 12 is transferred to the heat dissipation tank 31 and then to the gas such as air surrounding the heat dissipation tank 31. A fan 32 is provided outside the heat dissipation tank 31; the fan 32 generates a flow of the surrounding gas, causing heat from the heat dissipation tank 31 to be dissipated. As a result, heat from cooling liquid 12 is dissipated, lowering the temperature of cooling liquid 12. The cooled cooling liquid 12 then passes through the second tube 34 and the third tube 35 (the third tube 35 also constituting part of the flow channel forming member 25, like the first tube 33 and the second tube 34) and returns to cooling tank 20 from outlet 28 (in the example of FIG. 5, one end of the third tube 35).

In the electronic device 10B, by providing the circulator 24 with the heat dissipation unit 30, the temperature of cooling liquid 12 in cooling tank 20 can be reduced, making it easier to maintain cooling liquid 12 in cooling tank 20 at a low temperature. Additionally, because cooling liquid 12 efficiently removes heat from electronic elements 11 and efficiently transports heat away from cooling tank 20, there is no need to operate fan 32 at high speed, and thus the electronic device 10B can operate with relatively low noise.

### [2. Second Embodiment]

### [2 1. Configuration]

Description will now be given of the electronic device according to the second embodiment. As shown in FIG. 6, the electronic device 10C according to the second embodiment includes a circuit (referred to as functional circuit 43A) that converts a DC or AC input (indicated by arrow IN in FIG. 6) into a DC or AC output (indicated by arrow OUT in FIG. 6) in accordance with the functions of the electronic device. FIG. 6 is a diagram illustrating an exemplary configuration of the electronic device according to the second embodiment.

### (Functional Circuit)

The functional circuit 43A is not particularly limited, but may, for example, be a circuit that generates a large output, such as a high current for driving a motor or a transmission radio wave for a communication base station. Examples of such circuits include an inverter circuit, a converter circuit, a frequency conversion circuit, and a regulator circuit.

### (Functional Circuit Board)

In the electronic device 10C of the second embodiment, a circuit board having electronic elements mounted on a substrate body (referred to as functional circuit board 43) has the functional circuit 43A. Electronic elements for forming the functional circuit 43A may be any of the electronic elements 11 described in the first embodiment. From the standpoint of generating a large output, the electronic elements mounted on the functional circuit board 43 may be, for example, power semiconductors. The structure for mounting electronic elements on the substrate body may be the same as the element bonding portion 19 described in the first embodiment. The material of the substrate body may be the same as that of substrate body 17 described in the first embodiment.

### (Input and Output)

In the example of the electronic device 10C according to the second embodiment shown in FIG. 6, an input unit 44, such as a power supply, is provided on the input side, and an output unit 45 such as a motor or an antenna is provided on the output side. The input unit is connected to an input terminal of the functional circuit board 43, and the output unit is connected to an output terminal of the functional circuit board 43. However, this is merely an example, and the electronic device 10C according to the second embodiment only needs to be configured so as to be able to receive input to and output from the functional circuit board 43. In the case of motor driving, the functional circuit 43A includes a converter circuit and an inverter circuit composed of power semiconductors, the input unit 44 is a DC power supply device, the output unit 45 is a three phase AC motor, the input side wiring 46 comprises positive and negative lines, and the output side wiring 47 comprises three phase lines.

### (Cooling Liquid)

In the second embodiment, the functional circuit 43A is immersed in the cooling liquid 12. In the example of FIG. 6, because the functional circuit board 43 is immersed in the cooling liquid 12 contained in the internal space SP of cooling tank 20, a state in which the functional circuit 43A is immersed in the cooling liquid 12 is formed. Since the cooling liquid 12 is supercritical state passed water 21 as described in the first embodiment, detailed description thereof is omitted. Likewise, detailed description of cooling tank 20 is omitted because it is the same as in the first embodiment.

In the second embodiment, the functional circuit board 43 may include an immersion region R1 and a non-immersion region R2 as described in the first embodiment. Since the points regarding, for example, the preference for arranging electronic elements in the immersion region R1 are the same as those in the first embodiment, a description of the immersion region R1 and the non-immersion region R2 is omitted.

Even in the second embodiment, as in the first embodiment, Modified Examples 1 to 3 of the first embodiment may be applied.

### [2 2. Operation and Effects]

According to the electronic device 10C of the second embodiment, the same effects as those obtained by the electronic device 10 of the first embodiment described above can be achieved.

Next, a method for cooling electronic elements will be described. In the following, the method for cooling electronic elements may be referred to as the "cooling method of the present invention."

### [Cooling Method for Electronic Elements]

### [1. Configuration of the Cooling Method]

The cooling method of the present invention corresponds to a method for cooling electronic elements of an electronic device. The electronic device and the electronic elements to which the cooling method of the present invention is applied are, for example, the electronic devices of the present invention described above (for example, electronic device 10 and electronic devices 10A to 10C) and electronic element 11, respectively.

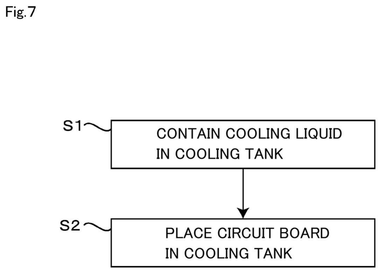

The cooling method of the present invention includes cooling the electronic element by immersing the electronic element in cooling liquid. For example, as shown in FIG. 7, the cooling method can be carried out by preparing a cooling tank similar to cooling tank 20 described above, containing cooling liquid in the cooling tank (step S1 in FIG. 7), and arranging a circuit board, on which the electronic element is mounted, in the cooling tank so that at least a portion of the circuit board is immersed in cooling liquid (step S2 in FIG. 7). In addition, this is merely an example, and the timing of containing cooling liquid in the cooling tank is not particularly limited; cooling liquid may be contained in the cooling tank after the circuit board has been placed therein.

In the cooling method of the present invention, the cooling liquid is supercritical state passed water. That is, the cooling liquid is water that has been transitioned from a state at a temperature exceeding the critical temperature and a pressure exceeding the critical pressure to a state at normal temperature and normal pressure. The supercritical state passed water can be produced in the same manner as the supercritical state passed water 21 described in connection with the electronic device of the present invention.

It is preferable that the cooling liquid flows while being contained in the cooling tank. The flow of the cooling liquid can be achieved by connecting the circulator to cooling tank. However, this is merely an example of a structure capable of achieving flow of the cooling liquid (referred to as a fluidization structure), and the fluidization structure is not limited to the circulator.

### [2. Operation and Effects of the Cooling Method]

According to the cooling method of the present invention, the same effects as those obtained by the electronic device of the present invention described above can be achieved.

From the description of the present specification, the following invention can be appreciated:
(A1) An electronic device comprising:
   an electronic element for performing electronic processing; and
   a cooling liquid for immersing and cooling the electronic element, wherein the cooling liquid is water that has been transitioned from a state at a temperature exceeding a critical temperature and a pressure exceeding a critical pressure to a state at normal temperature and normal pressure.
(A2) The electronic device according to (A1), further comprising a circuit board having circuit wiring electrically joined to terminals of the electronic element using metal.
(A3) The electronic device according to (A2), wherein the circuit board has an immersion region immersed in the cooling liquid and a non-immersion region not immersed in the cooling liquid, and wherein the electronic element is disposed in the immersion region.
(A4) The electronic device according to (A2) or (A3), wherein the circuit board is waterproof-coated.
(A5) The electronic device according to any one of (A1) to (A4), further comprising a cooling tank for storing the cooling liquid, wherein the cooling tank is provided with a circulator for circulating the cooling liquid, and wherein the circulator is configured to dissipate heat from the cooling liquid.
(A6) The electronic device according to (A3), wherein the circuit board comprises terminals for electrically connecting to an external device and/or a power supply, and wherein those terminals are disposed in the non-immersion region.
(A7) A method of cooling an electronic element of an information processing device having an electronic element that performs electronic processing, the method comprising:
   cooling the electronic element by immersing the electronic element in a cooling liquid;
   wherein the cooling liquid is water that has been transitioned from a state at a temperature exceeding a critical temperature and a pressure exceeding a critical pressure to a state at normal temperature and normal pressure.

- 10:: ELECTRONIC DEVICE
- 11:: ELECTRONIC ELEMENT
- 12:: COOLING LIQUID
- 13:: EXTERNAL CONNECTION TERMINAL
- 14:: EXTERNAL device
- 15:: CIRCUIT BOARD
- 20:: COOLING TANK
- 21:: SUPERCRITICAl-STATE-PASSED WATER
- 100:: PRESSURE RAISING UNIT
- 110:: TEMPERATURE RAISING UNIT
- 120:: PIPING
- R1:: IMMERSION REGION
- R2:: NON IMMERSION REGION
- SP:: INTERNAL SPACE

## Claims

1. An electronic device comprising:
an electronic element for performing electronic processing; and
a cooling liquid for immersing and cooling the electronic element;
wherein the cooling liquid is water that has been transitioned from a state at a temperature exceeding a critical temperature and a pressure exceeding a critical pressure to a state at normal temperature and normal pressure.

2. The electronic device of claim 1, further comprising a circuit board having circuit wiring electrically joined to terminals of the electronic element using metal.

3. The electronic device of claim 2, wherein the circuit board has an immersion region immersed in the cooling liquid and a non-immersion region not immersed in the cooling liquid, and the electronic element is disposed in the immersion region.

4. The electronic device of claim 2, wherein the circuit board is waterproof-coated.

5. The electronic device of claim 1 or 2, further comprising a cooling tank for storing the cooling liquid, wherein the cooling tank is provided with a circulator for circulating the cooling liquid, and wherein the circulator is configured to dissipate heat from the cooling liquid.

6. A method of cooling an electronic element of an information processing device having an electronic element for performing electronic processing, the method comprising:
cooling the electronic element by immersing the electronic element in a cooling liquid;
wherein the cooling liquid is water that has been transitioned from a state at a temperature exceeding a critical temperature and a pressure exceeding a critical pressure to a state at normal temperature and normal pressure.
